# EUROPÄISCHE PATENTSCHRIFT

(11) **EP 0 721 665 B1**
(45) Veröffentlichungstag und Bekanntmachung des Hinweises auf die Patenterteilung: **09.12.1998**
(21) Anmeldenummer: 94929506.7
(22) Anmeldetag: 30.09.1994
(51) Int. Cl.: H01L 29/861

(54) **HALBLEITERBAUELEMENT MIT HOHER DURCHBRUCHSSPANNUNG**
SEMICONDUCTOR COMPONENT WITH HIGH BREAKDOWN VOLTAGE
COMPOSANT A SEMI-CONDUCTEUR A TENSION DE CLAQUAGE ELEVEE

(30) Priorität: 01.10.1993 DE 4333661
(43) Veröffentlichungstag der Anmeldung: 17.07.1996
(73) Patentinhaber: Daimler-Benz Aktiengesellschaft, 70546 Stuttgart (DE)
(72) Erfinder: WONDRAK, Wolfgang, D-60385 Frankfurt am Main (DE); HELD, Raban, D-63776 Mömbris (DE)
(74) Vertreter: Fröhling, Werner Otto, Dr.
(86) Internationale Anmeldenummer: EP9403266
(87) Internationale Veröffentlichungsnummer: WO9510122

(56) Entgegenhaltungen:
- EP-A- 0 213 972
- EP-A- 0 335 741
- EP-A- 0 452 829
- DE-A- 3 806 164
- US-A- 4 037 243
- PROCEEDINGS OF THE 3RD INTERNATIONAL SYMPOSIUM ON POWER SEMICONDUCTOR DEVICES AND ICS, April 1991, BALTIMORE, US Seiten 27 - 30 Y.S. HUANG ET AL. 'Extension of RESURF principle to dielectrically isolated power devices' in der Anmeldung erwähnt

## Beschreibung

Die Erfindung bezieht sich auf ein Halbleiterbauelement mit wenigstens einer lateralen, eine hohe Durchbruchspannung aufweisenden Halbleiterstruktur aus einem Substrat, einer an das Substrat angrenzenden dielektrischen Schicht, einer auf der dielektrischen Schicht angeordneten niedrig dotierten Halbleiterzone und mit stark dotierten Halbleiterzonen des Halbleiterbauelements, die in die niedrig dotierte Halbleiterzone von der Oberfläche des Halbleiterbauelements her hineinragen.

Eine derartige Halbleiterstruktur ist aus dem Aufsatz "Extension of the Resurf Principle to Dielectrically Isolated Power Devices" des Konferenzberichtes Conf. Report. ISPSD 1991, Baltimore, Seiten 27 - 30, bekannt. Hierbei handelt es sich um die typische Struktur einer lateralen Diode auf einem dielektrisch isolierten Substrat. Derartige Strukturen, die dem allgemeinen Begriff "smart power technology" zuzuordnen sind, stellen ein Bindeglied zwischen digitalen Steuerungen und Leistungsbauelementen dar. Diese Technologie ermöglicht die Integration von Logik-, Schutz- und Diagnosefunktionen in Leistungsbauelementen.

Ein wesentlicher Gesichtspunkt der angesprochenen Technologie besteht darin, auf einem sogenannten Halbleiterwafer, der im folgenden nur als Halbleiter bezeichnet werden soll, mehrere Leistungsbauelemente zu integrieren, wobei die einzelnen Bauelemente gegeneinander vollständig isoliert sind.

Die gemeinsame Anordnung von logischen Schaltungen und Leistungsbauelementen in einem Chip ist in dem Aufsatz "Impact of Dielectric Isolation Technology on Power ICs" des Konferenzberichtes Conf. Report ISPSD 1991, Baltimore, Seiten 16 - 21 beschrieben. Die bei mehreren Bauelementen erforderliche Isolation ist so durchzuführen, daß das jeweilige Bauelement nach allen Seiten hin gegenüber den übrigen angrenzenden Halbleiterbereichen elektrisch isoliert ist. Die seitliche Isolation erfolgt in der Regel in der Weise, daß Gräben um das Bauelement geätzt werden, die anschließend mit einem Dielektrikum ausgefüllt werden. Die dielektrische Isolation parallel zur Oberfläche des Halbleiters, also in vertikaler Richtung, erfolgt entweder durch die Bildung eines in Sperrichtung belasteten pn-übergangs oder durch Verendung eines Dielektrikums, wie z. B. Siliziumoxid. Die Tendenz geht eindeutig zur dielektrischen Isolation hin, da bei dieser Technologie parasitäre Elemente vermieden werden und u. a. auch ein einfacheres Design bei erhöhter Störsicherheit möglich ist.

Zur Herstellung dielektrisch isolierter Halbleiterwafer, bestehend aus einem Substrat, einer an das Substrat angrenzenden dielektrischen Schicht und einer darauf angeordneten Halbleiterzone, sind verschiedene Verfahren bekannt. Wie aus der Europäischen Offenlegungsschrift EP-A2 0 335 741 bekannt ist, sind mit der Direktverbindungstechnik hergestellte Halbleiterwafer für Hochspannungsbauelemente am besten geeignet, da sie die besten Materialeigenschaften der auf der dielektrischen Schicht angeordneten Halbleiterzone gewährleisten.

Weiterhin ist aus der EP-A2 0 213 972 bekannt, daß durch Ionenimplantation in den Gateisolator von MOS-Transistoren positive Ladungen im Gateisolator erzeugt werden können, was die gezielte Einstellung der Schwellenspannung erlaubt.

Die auf elektrisch isolierten Halbleiterwafern erreichten maximalen Sperrspannungen bzw. Durchbruchsspannungen der Bauelemente werden einerseits durch die Isolationsfähigkeit des "vergrabenen Dielektrikums" bestimmt und zum anderen durch die Oberflächeneigenschaften in den Oberflächenbereichen, in denen die pn-übergänge an die Oberfläche treten. Zur Vermeidung eines Oberflächendurchbruchs werden u. a. sogenannte Feldplatten im Bereich der pn-übergänge an der Oberfläche eingesetzt.

Andererseits wird der Spannungsdurchbruch hauptsächlich dadurch begrenzt, daß die gesamte Spannung zwischen dem in der Regel geerdeten Substrat und den auf hohem Potential liegenden, hochdotierten Bereichen der Halbleiterbauelemente aufgebaut wird, was zu hohen Feldstärken führt. Einerseits führt die Erhöhung der Dicke der auf der dielektrischen Schicht angeordneten Halbleiterzone zur Erhöhung der Durchbruchsspannung zu erheblichen Schwierigkeiten, da mit zunehmender Dicke der Aufwand für die seitliche Isolation durch Trennätzen und anschließender Auffüllung mit Isolationsmaterial schwierig wird. Andererseits kann zur Erzielung hoher Durchbruchsspannungen die Dicke des vergrabenen Dielektrikums nicht beliebig groß gemacht werden, da sonst wegen der zu geringen Wärmeleitfähigkeit eine unzureichende Abführung der Verlustleistung in Kauf genommen werden muß, was allgemein zu thermischen Problemen für die erzielbaren Parameter und den Betrieb der Bauelemente führt.

Bei Verwendung von Siliziumoxidschichten haben sich Dicken der dielektrischen Schicht im Bereich 0,5 bis 4,5 µm als noch brauchbar erwiesen.

Zur Erzielung höherer Durchbruchsspannungen für laterale, dielektrisch isolierte Bauelemente in Halbleitern aus Silizium mit einer Dicke der Driftzone unter 30 µm wurden verschiedene Maßnahmen diskutiert, wie z. B. zusätzliche Diffusionsgebiete im Substrat, die mit den dielektrisch isolierten Bauelementen verbunden sein können. Diese Lösung hat jedoch den Nachteil, daß sie technisch nur schwer zu realisieren ist und andererseits wiederum die ansonsten gute dielektrische Isolation stark beeinträchtigt.

Eine andere bekannte Maßnahme zur Erreichung höherer Durchbruchsspannungen ist die Einbringung vergrabener Dotierungen an der Grenzfläche zu der dielektrischen Schicht, wie der Patentschrift DE-C2 38 06 164 zu entnehmen ist. Diese Maßnahme ist dort in einer Fig. 2 dargestellt. Damit erfolgt eine etwas günstigere Potentialverteilung in den Bauelementen; trotzdem ist die Erhöhung der Durchbruchsspannung relativ gering und außerdem abhängig von der Dicke der dielektrischen Schicht. Die maximal berichtete Durchbruchsspannung liegt bei 600 V für eine Siliziumschichtdicke von 20 µm. Dies reicht für verschiedene Anwendungsgebiete nicht aus.

Eine weitere Maßnahme zur Erreichung höherer Durchbruchsspannungen ist in dem Aufsatz "Influence of the Backgate-Voltage on the Breakdown-Voltage of SOI Power Devices", Electrochemical Society Proceedings, Vol. 92-7, 1992, S. 427 - 432 beschrieben. Eine besonders günstige Potentialverteilung in den Bauelementen und damit eine deutliche Steigerung der Durchbruchsspannung wird dadurch erzielt, daß an das Substrat ein Potential angelegt wird, das zwischen den Werten des Source- und Drainpotentials liegt. Die Nachteile bei dieser Maßnahme sind, daß die für viele Anwendungen geforderte Erdung des Substrats nicht eingehalten werden kann, und daß das Substratpotential alle in der niedrig dotierten Halbleiterschicht integrierten Bauelemente gleichsam beeinflußt.

Vorteilhaft wäre eine Halbleiterstruktur, die bei gleicher oder geringerer Dicke der halbleitenden Schicht höhere Durchbruchsspannungen besitzt. Dabei sollen die übrigen Bauelementeigenschaften nicht beeinträchtigt werden.

Der Erfindung liegt die Aufgabe zugrunde, ein Halbleiterbauelement mit wenigstens einer Halbleiterstruktur zu schaffen, bei dem eine ausreichend hohe Durchbruchsspannung auch mit einer dünnen Halbleiterschicht in technologisch einfacher Weise realisierbar ist. Dabei soll gleichzeitig die Einbringung von zusätzlichen Rekombinations-Generationszentren vermieden werden.

Diese Aufgabe wird bei einem Halbleiterbauelement der eingangs beschriebenen Art erfindungsgemäß durch die im Kennzeichen des Anspruchs 1 aufgeführten Merkmale gelöst.

Für die Erfindung wesentlich ist, daß innerhalb der an das Substrat angrenzenden dielektrischen Schicht feste Ladungen eingelagert sind, welche die elektrische Feldstärke im sperrenden Bauelement reduzieren. Durch die Anwesenheit dieser festen Ladungen wird ein Teil des Spannungsabfalls in die dielektrische Schicht hinein verschoben, wodurch eine Reduzierung der elektrischen Feldstärke in den niedrig dotierten Halbleiterzonen und eine höhere Durchbruchsspannung der Bauelemente erreicht wird.

Als weitere Halbleiterzonen sind insbesondere eine erste Halbleiterzone, die einen ersten Leitfähigkeitstyp mit einer höheren Fremdatomkonzentration als die niedrig dotierte Halbleiterzone aufweist, und eine zweite Halbleiterzone in die Driftzone eingelassen, die bei einem zweiten Leitfähigkeitstyp eine Fremdatomkonzentration aufweist, die höher ist als diejenige der Driftzone und die außerhalb der ersten Halbleiterzone liegt.

Eine derartige Anordnung bildet eine Diode. Zweckmäßigerweise werden für den Fall einer gegenüber dem Substratpotential positiven Sperrspannung der Diode positive Ladungen in der dielektrischen Schicht eingelagert, die lateral homogen wenigstens in dem Bereich zwischen der ersten und der zweiten Halbleiterzone angeordnet sind. Die Halbleiterstruktur kann dabei so ausgebildet sein, daß die erste und zweite Halbleiterzone bis zur dielektrischen Schicht verlaufen oder jeweils einen Abstand zu dieser aufweisen.

Bei einer anderen zweckmäßigen Ausführungsform sind die (positiven) Ladungen in der dielektrischen Schicht wenigstens in dem Bereich zwischen der ersten und zweiten Halbleiterzone derart angeordnet, daß ihre Konzentration unterhalb der Halbleiterzone mit der größten Potentialdifferenz gegenüber dem Substrat am höchsten ist und lateral mit zunehmendem Abstand abfällt.

Weitere Ausgestaltungen des Halbleiterbauelements sind den Unteransprüchen zu entnehmen.

Die Erfindung wird im folgenden anhand von in einer Zeichnung dargestellten Ausführungsbeispielen näher beschrieben.

Es zeigen:
- Fig. 1: eine herkömmliche Halbleiterstruktur mit einer Diode und einer lateralen Trennstruktur;
- Fig. 2: eine herkömmliche Halbleiterstruktur mit einer Diode höherer Durchbruchsspannung und einer lateralen Trennstruktur;
- Fig. 3: eine Halbleiterstruktur mit einer ersten Ausführungsform einer Diode und mit lateral homogen verteilten festen Ladungen in der dielektrischen Schicht im Querschnitt;
- Fig. 4: eine Halbleiterstruktur mit einer zweiten Ausführungsform einer Diode und mit lateral homogen verteilten festen Ladungen in der dielektrischen Schicht im Querschnitt;
- Fig. 5: eine Halbleiterstruktur mit einer ersten Ausführungsform einer Diode und mit lateral inhomogen verteilten festen Ladungen in der dielektrischen Schicht im Querschnitt und
- Fig. 6: eine Halbleiterstruktur mit einer zweiten Ausführungsform einer Diode und mit lateral inhomogen verteilten festen Ladungen in der dielektrischen Schicht im Querschnitt.

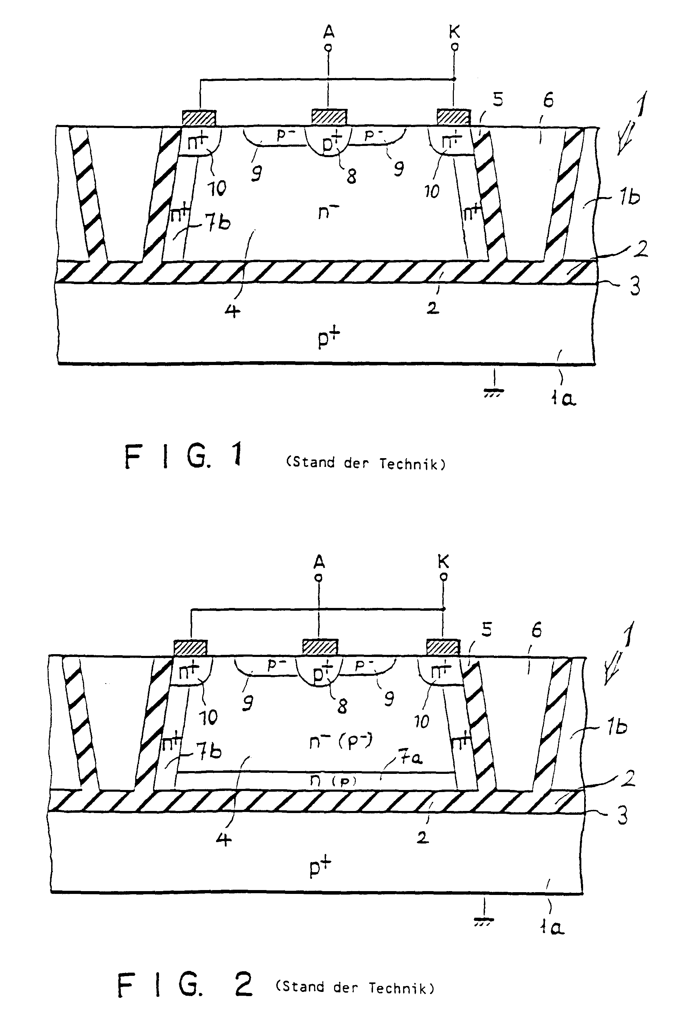

Die in Fig. 1 dargestellte Anordnung nach dem Stand der Technik besteht aus einer durch Verbindung eines Siliziumsubstrats 1a und eines n-Si-Substrats 1b nach Direktverbindungstechnik gebildeten Halbleiterstruktur 1 mit einem an der Verbindungsgrenzfläche 3 erzeugten Oxidfilm 2, im folgenden auch dielektrische Schicht 2 genannt. Zur lateralen Isolation ist ein Teil des n-Substrats 1b als Graben mindestens bis zum Oxidfilm 2 geätzt, so daß eine inselförmige n-Schicht 4 gebildet wird. Der Graben ist durch einen Oxidfilm 5 und durch eine Schicht aus polykristallinem Silizium 6 gefüllt. In der n-Schicht 4 ist eine p⁺-Schicht 8, umgeben von einer p-Schicht 9 angeordnet, so daß eine Diode gebildet wird.

In einem Flächenteil der n-Schicht wird eine n⁺-Schicht 10 zur besseren Kontaktierbarkeit erzeugt. Da das Potential am Substrat 1a normalerweise auf OV gesetzt ist und da der dünne Oxidfilm eine relativ hohe Dielektrizitätskonstante hat, liegt der größte Teil der an die Diode angelegten Sperrspannung in der Verarmungsschicht unterhalb der n⁺-Schicht 10. Die hierdurch entstehende ungünstige Verteilung des elektrischen Feldes ist in der DE-C2 38 06 164 im Aufsatz "Impact of Dielectric Isolation Technology on Power ICs" des Konferenzbandes Conf. Report ISPSD 1991, Baltimore, Seiten 16 - 21, beschrieben.

Die in Fig. 2 dargestellte Diodenanordnung nach der DE-C2 38 06 164 ist ähnlich aufgebaut wie die in Fig. 1 gezeigte, nur sind hier zusätzlich eine n-dotierte Zone 7a auf dem Bodenabschnitt der Si-Schicht 4 und eine hochdotierte Zonen 7b am Umfang der Schicht 4 ausgebildet.

Bei geeigneter Dotierung dieser Schichten wird bei Anlegen einer Sperrvorspannung der Diode die Schicht 7a auf dem Bodenabschnitt verarmt, wobei in seitlicher Richtung eine Potentialdifferenz erzeugt wird, die die Spannung zwischen den Elektroden A und K aufteilt, wodurch ein Teil der angelegten Spannung durch den Oxidfilm 2 aufgenommen wird. Die erzeugte Potentialdifferenz in seitlicher Richtung ist aber dadurch begrenzt, daß mit Erhöhung der Dotierungskonzentration in der Schicht 7a bald keine vollständige Verarmung mehr auftritt und das elektrische Feld unterhalb der Zone 8 rasch ansteigt.

Zudem macht die technische Realisierung dieser Lösung Probleme, da die Zone 7a vor der Herstellung der Bauelementstruktur (Zonen 5, 6, 7b, 8, 9 und 10) hergestellt werden muß, und deshalb die zulässigen Prozeßtemperaturen eingeschränkt werden müssen. Ansonsten diffundiert die Zone 7a auf eine unzulässige Tiefe aus.

In den folgenden Ausführungsbeispielen der Erfindung wird der Einfachheit halber jeweils eine Diodenstruktur beschrieben, wobei die festen Ladungen der übersichtlichkeit halber in der Mitte der dielektrischen Schicht skizziert sind.

Die Erfindung kann aber auch für alle anderen unipolaren und bipolaren Bauelemente eingesetzt werden. Beispielsweise können die Dotierungen n und p der Beispiele vertauscht werden. Die Bauelemente müssen nicht symmetrisch ausgelegt sein, eine laterale Isolation durch Trenngräben kann auch vorgenommen werden.
Des weiteren sind bei allen Bauelementen auch die bekannten Maßnahmen zur Reduzierung von Oberflächenfeldstärken, wie z. B. Widerstandsfeldplatten und Feldplatten, aber auch die Verwendung von niedrigdotierten Zonen (JTE) denkbar. Als Dielektrika sind auch andere Stoffe als SiO₂ einsetzbar, die thermisch oder per Abscheideverfahren auf die Oberflächen aufgebracht werden wie beispielsweise Si₃N₄ Al₂O₃, AIN etc.

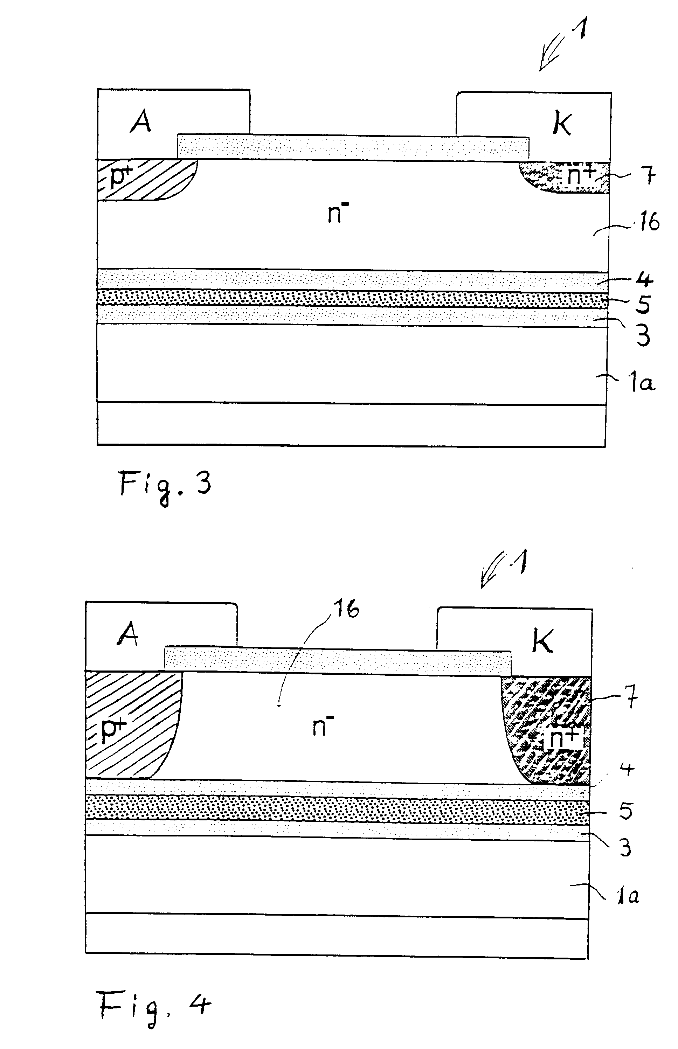

Die in Fig. 3 dargestellte Anordnung besteht aus einer durch die Verbindung eines Siliziumsubstrats 1a und eines n-dotierten Substrats 1b nach der Direktverbindungstechnik gebildeten Halbleiterstruktur 1 mit einer an der Oberfläche 3 des Si-Substrats 1a erzeugten dielektrischen Schicht 4, beispielsweise einer Oxidschicht, und der darüber liegenden n-Schicht 1b.

In der dielektrischen Schicht 4 sind, beispielsweise durch Ionenimplantation vor dem Direktverbindungsprozeß eingebracht, lateral homogen feste positive Ladungen in einer Schicht 5 vorhanden. In der n-Schicht 1b ist eine erste Halbleiterzone eines ersten Leitfähigkeitstyps, die eine höhere Fremdatomkonzentration als die n-Schicht 1b aufweist, vorgesehen. Die erste Halbleiterzone ist eine p⁺-Schicht 6, so daß eine Diode gebildet wird.

In einem Flächenteil der n-Schicht 1b ist separat von der p⁺-Schicht 6 als zweite Halbleiterzone eine n⁺-Schicht 7 zur besseren Kontaktierung gebildet. Die Halbleiteroberfläche wird durch eine Oxidschicht 8 geschützt. Die p⁺-Schicht 6 ist als Anode A kontaktiert, die n⁺-Schicht 7 als Kathode.

Beim Anlegen einer positiven Sperrspannung an die Kathode der Diode baut sich bei geerdetem Substrat die volle Potentialdifferenz zwischen der n⁺-Schicht 7 und der Oberfläche 3 des Si-Substrats 1a auf. Die positiven Ladungen 5 bewirken einen Spannungsabfall vertikal in der dielektrischen Schicht 4, so daß die elektrische Feldstärke in der n-Schicht 1b unterhalb der n⁺-Schicht 7 verringert wird.

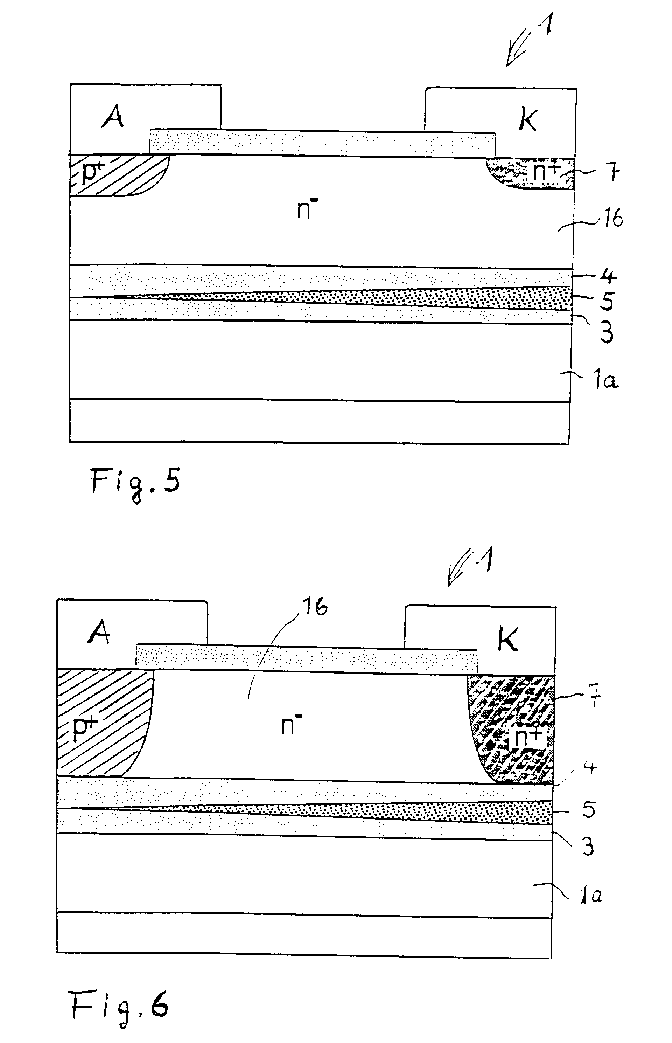

Die in Fig. 4 dargestellte Anordnung unterscheidet sich von der Anordnung gem. Fig. 3 darin, daß sich die p⁺-Schicht 6 und die n⁺-Schicht 7 bis zur dielektrischen Schicht 4 erstrecken. Bei dieser Ausführungsform wird der Spannungsabfall unterhalb der Kathode praktisch vollständig in die dielektrische Schicht 4 hinein verschoben. Dabei bewirken die positiven Ladungen 5 gleichzeitig eine Verringerung der elektrischen Feldstärke an der Krümmung der n⁺-Schicht 7, wodurch eine erhebliche Erhöhung der Durchbruchsspannung erreicht wird.

Die in Fig. 5 dargestellte Anordnung unterscheidet sich von der Anordnung gem. Fig. 3 darin, daß die Konzentration der positiven Ladungen 5 in der dielektrischen Schicht 4 unterhalb der n⁺-Schicht 7 am höchsten ist und unterhalb der p⁺-Schicht 6 am geringsten. Bei dieser Ausführungsform wird erreicht, daß unterhalb der n⁺-Schicht 7 eine hohe Spannungsdifferenz in der dielektrischen Schicht 4 aufgenommen wird, ohne daß gleichzeitig das Potential in der n-Schicht 1b unterhalb der p⁺-Schicht 6 ansteigt. Auf diese Weise kann eine besonders vorteilhafte Potentialverteilung in der n-Schicht 1b erzielt werden.

Die in Fig. 6 dargestellte Anordnung unterscheidet sich von der Anordnung gem. Fig. 5 darin, daß sich die p⁺-Schicht 6 und die n⁺-Schicht 7 bis zur dielektrischen Schicht 4 erstrecken. Bei dieser Ausführungsform wird im Sperrbetrieb der Spannungsabfall unterhalb der Kathode praktisch vollständig in die dielektrische Schicht 4 hinein verschoben.

Durch die laterale Verteilung der positiven Ladungen 5 kann dabei der laterale Feldstärkeverlauf in der n-Schicht 1b vorgegeben werden, so daß sich nahezu ideale Verhältnisse für die Durchbruchsspannung der Diode erreichen lassen. Im Durchlaßbetrieb werden durch die Existenz der festen positiven Ladungen negative Ladungsträger in der n-Schicht 1b influenziert, was gleichzeitig zu einer erwünschten Verringerung des Durchlaßwiderstands führt.

## Patentansprüche

1. Halbleiterbauelement mit wenigstens einer lateralen, eine hohe Durchbruchsspannung aufweisenden Halbleiterstruktur aus einem Substrat (1a), einer an das Substrat (1a) angrenzenden dielektrischen Schicht (4), einer auf der dielektrischen Schicht (4) angeordneten niedrig dotierten Halbleiterzone (1b) und mit stark dotierten Halbleiterzonen (6, 7) des Halbleiterbauelements, die in die niedrig dotierte Halbleiterzone (1b) von der Oberfläche des Halbleiterbauelements her hineinragen,
**dadurch gekennzeichnet**,
daß innerhalb der an das Substrat (1a) angrenzenden dielektrischen Schicht (4) wenigstens gegenüber demjenigen Bereich der niedrig dotierten Halbleiterzone (1b), der im Sperrzustand des Halbleiterbauelements gegenüber dem Substrat ein hohes Potential aufweist, feste Ladungen eingelagert sind, die die elektrische Feldstärke im sperrenden Bauelement reduzieren.

2. Halbleiterbauelement nach Anspruch 1,
**dadurch gekennzeichnet**,
daß in die niedrig dotierte Halbleiterzone (1b) von der Oberfläche her eine erste Halbleiterzone (6), die einen ersten Leitungstyp mit einer höheren Fremdatomkonzentration als die niedrig dotierte Halbleiterzone (1b) aufweist und eine zweite Halbleiterzone (7) eingelassen ist, die einen zweiten Leitungstyp mit einer Fremdatomkonzentration, die höher ist als diejenige der niedrig dotierten Halbleiterzone (1b) ist, aufweist und die außerhalb der ersten Halbleiterzone liegt.

3. Halbleiterbauelement nach Anspruch 1 oder 2,
**dadurch gekennzeichnet**,
daß die festen Ladungen in einer Schicht (5) lateral homogen angeordnet sind.

4. Halbleiterbauelement nach Anspruch 1 oder 2,
**dadurch gekennzeichnet**,
daß die festen Ladungen in der dielektrischen Schicht (4) unterhalb der Zonen, die im Sperrbetrieb die höheren Potentialdifferenzen gegenüber dem Substrat (1a) aufweisen, in der höchstmöglichen Konzentration eingebracht sind, und ihre Konzentration lateral zu den Zonen mit niedrigen Potentialdifferenzen hin stetig abnimmt.

5. Halbleiterbauelement nach einem der Ansprüche 1 bis 4,
**dadurch gekennzeichnet**,
daß als Halbleiter Silizium verwendet wird.

6. Halbleiterbauelement nach einem der Ansprüche 1 bis 4,
**dadurch gekennzeichnet**,
daß die dielektrische Schicht (4) aus AIN, BN, Si₃N₄ oder SiO₂, oder einer Mischung dieser Materialien besteht.

7. Halbleiterbauelement nach einem der Ansprüche 1 bis 6,
**dadurch gekennzeichnet**,
daß die festen Ladungen positive Ladungen sind.

8. Halbleiterbauelement nach einem der Ansprüche 1 bis 7,
**dadurch gekennzeichnet**,
daß die festen Ladungen durch eine nicht-stöchiometrische Zusammensetzung der dielektrischen Schicht hervorgerufen werden.

9. Halbleiterbauelement nach nach einem der Ansprüche 1 bis 7,
**dadurch gekennzeichnet**,
daß die festen Ladungen in der dielektrischen Schicht (4) durch Bestrahlung mit hochenergetischen Teilchen hervorgerufen werden.

10. Halbleiterbauelement nach Anspruch 7,
**dadurch gekennzeichnet,**
daß die festen positiven Ladungen durch die Implantation von positiven Ionen bereitgestellt werden.

11. Halbleiterbauelement nach Anspruch 10,
**dadurch gekennzeichnet**,
daß die positiven Ionen Cäesium-Ionen sind.

12. Halbleiterbauelement nach Anspruch 10,
**dadurch gekennzeichnet**,
daß die positiven Ionen Iod-Ionen sind.

13. Halbleiterbauelement nach Anspruch 10,
**dadurch gekennzeichnet**,
daß die positiven Ionen Bor-Ionen sind.

14. Halbleiterbauelement nach Anspruch 10,
**dadurch gekennzeichnet**,
daß die positiven Ionen Silizium-Ionen sind.

## Claims

1. Semiconductor component with at least one lateral semiconductor structure, which has a high breakdown voltage, consisting of a substrate (1a), a dielectric layer (4) adjoining the substrate (1a), a low-doped semiconductor zone (1b) arranged on the dielectric layer (4), and with strongly-doped semiconductor zones (6, 7) of the semiconductor component, which project from the surface of the semiconductor component into the low-doped semiconductor zone (1b), characterised thereby that fixed charges, which reduce the electric field strength in the blocking component, are stored within the dielectric layer (4), which adjoins the substrate (1a), at least opposite that region of the low-doped semiconductor zone (1b) which has a high potential relative to the substrate in the blocking state of the semiconductor component.

2. Semiconductor component according to claim 1, characterised thereby that a first semiconductor zone (6), which has a first conductivity type with a higher foreign atom concentration than the low-doped semiconductor zone (1b), and a second semiconductor zone (7), which has a second conductivity type with a foreign atom concentration higher than that of the low-doped semiconductor zone (1b) and which lies outside the first semiconductor zone, are embedded in the low-doped semiconductor zone (1b) from the surface.

3. Semiconductor component according to claim 1 or 2, characterised thereby that the fixed charges are arranged laterally homogeneously in a layer (5).

4. Semiconductor component according to claim 1 or 2, characterised thereby that the fixed charges are inserted in the highest possible concentration in the dielectric layer (4) below the zones, which have the higher potential differences relative to the substrate (1a) in the blocking operation, and their concentration constantly decreases laterally relative to the zones with low potential differences.

5. Semiconductor component according to one of claims 1 to 4, characterised thereby that silicon is used as the semiconductor.

6. Semiconductor component according to one of claims 1 to 4, characterised thereby that the dielectric layer (4) consists of AIN, BN, Si₃N₄ or SiO₂, or a mixture of these materials.

7. Semiconductor component according to one of claims 1 to 6, characterised thereby that the fixed charges are positive charges.

8. Semiconductor component according to one of claims 1 to 7, characterised thereby that the fixed charges are produced by a non-stoichiometric composition of the dielectric layer.

9. Semiconductor component according to one of claims 1 to 7, characterised thereby that the fixed charges in the dielectric layer (4) are produced by irradiation with high-energy particles.

10. Semiconductor component according to claim 7, characterised thereby that fixed positive charges are formed by implantation of positive ions.

11. Semiconductor component according to claim 10, characterised thereby that the positive ions are cesium ions.

12. Semiconductor component according to claim 10, characterised thereby that the positive ions are iodine ions.

13. Semiconductor component according to claim 10, characterised thereby that the positive ions are boron ions.

14. Semiconductor component according to claim 10, characterised thereby that the positive ions are silicon ions.

## Revendications

1. Composant à semi-conducteur avec au moins une structure de semi-conducteur latérale, présentant une tension de claquage élevée, en un substrat (1a), une couche diélectrique (4) avoisinant le substrat (1a), une zone semi-conductrice (1b) faiblement dotée disposée sur la couche diélectrique (4) et avec des zones semi-conductrices fortement dotées (6, 7) du composant à semi-conducteur qui font saillie dans la zone semi-conductrice faiblement dotée (1b) depuis la surface du composant à semi-conducteur,
caractérisé
en ce qu'à l'intérieur de la couche diélectrique (4) avoisinant le substrat (1a), au moins par rapport à la région de la zone semi-conductrice faiblement dotée (1b) qui, à l'état de blocage du composant à semi-conducteur présente par rapport au substrat un potentiel élevé, des charges solides sont déposées qui réduisent l'intensité du champ électrique dans le composant bloquant.

2. Composant à semi-conducteur selon la revendication 1,
caractérisé
en ce qu'il est déposé dans la zone semi-conductrice faiblement dotée (1b) depuis la surface une première zone semi-conductrice (6) qui présente un premier type conducteur avec une concentration plus élevée en atomes étrangers que la zone semi-conductrice faiblement dotée (1b), et une deuxième zone semi-conductrice (7) qui présente un deuxième type conducteur avec une concentration en atomes étrangers qui est plus élevée que celle de la zone semi-conductrice faiblement dotée (1b) et qui se situe à l'extérieur de la première zone semi-conductrice.

3. Composant à semi-conducteur selon la revendication 1 ou 2,
caractérisé
en ce que les charges solides sont disposées dans une couche (5) d'une manière homogène latéralement.

4. Composant à semi-conducteur selon la revendication 1 ou 2,
caractérisé
en ce que les charges solides dans la couche diélectrique (4) en dessous des zones qui présentent à l'état de blocage les différences de potentiel plus élevées par rapport au substrat (1a), sont introduites selon la concentration la plus élevée possible et que leur concentration diminue continuellement latéralement vers les zones ayant des différences de potentiel plus faibles.

5. Composant à semi-conducteur selon l'une des revendications 1 à 4,
caractérisé
en ce qu'il est utilisé comme semi-conducteur du silicium.

6. Composant à semi-conducteur selon l'une des revendications 1 à 4,
caractérisé
en ce que la couche diélectrique (4) est constituée de AIN, BN, Si₃N₄ ou SiO₂, ou d'un mélange de ces matériaux.

7. Composant à semi-conducteur selon l'une des revendications 1 à 6,
caractérisé
en ce que les charges solides sont des charges positives.

8. Composant à semi-conducteur selon l'une des revendications 1 à 7,
caractérisé
en ce que les charges solides sont provoquées par une composition non stoechiométrique de la couche diélectrique.

9. Composant à semi-conducteur selon l'une des revendications 1 à 7,
caractérisé
en ce que les charges solides dans la couche diélectrique (4) sont provoquées par une irradiation avec des particules hautement énergétiques.

10. Composant à semi-conducteur selon la revendication 7,
caractérisé
en ce que les charges positives solides sont préparées par l'implantation d'ions positifs.

11. Composant à semi-conducteur selon la revendication 10,
caractérisé
en ce que les ions positifs sont des ions de césium.

12. Composant à semi-conducteur selon la revendication 10,
caractérisé
en ce que les ions positifs sont des ions d'iode.

13. Composant à semi-conducteur selon la revendication 10,
caractérisé
en ce que les ions positifs sont des ions de bore.

14. Composant à semi-conducteur selon la revendication 10,
caractérisé
en ce que les ions positifs sont des ions de silicium.
